**Europäisches Patentamt**

**European Patent Office**

**Office européen des brevets**

(19)

(11) Veröffentlichungsnummer : **0 430 864 A2**

## (12) EUROPÄISCHE PATENTANMELDUNG

(21) Anmeldenummer : 90810153.8

(22) Anmeldetag : 01.03.90

(51) Int. Cl.$^5$ : **H01L 21/48, H01L 23/538**

(30) Priorität : 01.12.89 CH 4306/89

(43) Veröffentlichungstag der Anmeldung :
05.06.91 Patentblatt 91/23

(84) Benannte Vertragsstaaten :
**AT BE CH DE FR GB IT LI NL SE**

(71) Anmelder : Oerlikon-Contraves AG
Schaffhauserstrasse 580
CH-8052 Zürich (CH)

(72) Erfinder : Sutcliffe, Emile, Dr.
Pilgerstrasse 32
CH-5405 Baden (CH)
Erfinder : Arnesson, Jörgen, Dr.
Im Brünneli 2
CH-8152 Opfikon (CH)
Erfinder : Bay, Christian
Neubrunnenstrasse 192
CH-8046 Zürich (CH)

(74) Vertreter : Frei, Alexandra Sarah
Frei Patentanwaltsbüro Hedwigsteig 6
Postfach 95
CH-8029 Zürich (CH)

(54) **Verfahren zur Herstellung von elektrischen Verbindungen auf einem Universalsubstrat und Vorrichtung dazu.**

(57)    Das Verfahren zum Verdrahten von Substraten mit einem Universalmuster von Leiterbahnen und einer grossen Vielzahl von Verbindungsmöglichkeiten, zeichnet sich dadurch aus, dass aus der Menge aller Verbindungsmöglichkeiten eine für die Applikation nötige Menge von Verbindungsmöglichkeiten ausgeschieden wird und diese Applikationsmenge auf weitere, die Schaltung realisierende Verdrahtungs-Möglichkeiten untersucht wird, wobei die zusätzlich aufgefundene Menge von Möglichkeiten als Korrekturmenge bei der Verdrahtung zur Verfügung gestellt wird.

Der Vorteil eines solchen Korrekturpotentials besteht darin, dass Layout- oder Kontaktierfehler in einem zweiten Durchlauf korrigiert werden können, wodurch der Ausschuss gemindert wird.

FIG. 2

EP 0 430 864 A2

## VERFAHREN ZUR HERSTELLUNG VON ELEKTRISCHEN VERBINDUNGEN AUF EINEM UNIVERSALSUBSTRAT UND VORRICHTUNG DAZU

Die Erfindung liegt im Gebiet der elektrischen Schaltungstechnik und betrifft ein Verfahren zur Herstellung von elektrischen Verbindungen auf einem Universalsubstrat, das eine Vielzahl von Verbindungsmöglichkeiten aufweist, sowie eine Vorrichtung zu Ausführung dieses Verfahrens.

In der elektrischen Schaltungstechnik werden für Prototypen und Kleinserien vorzugsweise Universalsubstrate verwendet. Das sind "Schaltungsplatinen" mit einer Vielzahl von angelegten Verbindungs- und Kontaktmöglichkeiten, die nach Bedarf nachträglich untereinander verbunden und kontaktiert werden. Auf diese Weise ist es möglich, ohne einen bestimmten Leiterbahnen-Layout auf demselben Platinentyp eine Vielzahl verschiedener elektronischer Schaltungen anzulegen. Allerdings handelt es sich bei diesen "Schaltungsplatinen" nicht um Leiterplatten im herkömmlichen Sinn, sondern um sehr dicht mit Leitungen belegte Substrate, auf welche in Hybridtechnik die IC's und andere Komponenten direkt aufgebondet werden. In der Regel besteht solch ein Substrat aus einer Keramikbasis mit einem Leiterbahnenmuster. Bei Universalsubstraten sind in verschiedenen Ebenen mindestens zwei Leiterbahnenmuster so angelegt, dass eine möglichst grosse Anzahl von Schaltungen darauf realisiert werden können. Die gewünschte Leiterbahnenstruktur wird durch nachträgliches Kontaktieren und/oder Trennen von Leiterbahnkreuzungen bzw. Leiterbahnstücken, die zwei verschiedenen Ebenen angehören, ausgebildet. Ein Substrat dieser Art ist bspw. im Europäischen Patent 0'167'732 der Anmelderin beschrieben.

Die Vielfalt der Schaltungsmöglichkeiten aller Leiterbahnen und deren Kontaktierpunkte bei solchen Universalsubstraten stellt den Anwender vor ganz neue Probleme. Da muss einmal aus der Menge aller Möglichkeiten die Applikation, das heisst, die gewünschte Verschaltung (Verdrahtung, Beschaltung) durch Kontaktieren und/oder Trennen, herausgefunden werden. Damit ist es aber noch nicht getan, denn man muss davon ausgehen können, dass bei evtl. Beschaltungsfehlern in der Layout-Phase auf dem Substrat noch Korrekturen in Form von Ausweichleitungen angelegt werden müssen. Um dies in die Tat umzusetzen ist ein Optimierungsprozess unumgänglich. Ferner sollte bei der physikalischen Durchführung der Verschaltung, also der Kontakt- und/oder Trennoperationen, durch eine adäquate Maschinensteuerung solch ein Vorgang möglichst schnell ablaufen können. Dies alles muss in einem Mikro-Milieu durchführbar sein, in welchem der Mensch ohne optische Hilfsmittel nichts mehr ausrichten kann. Somit muss die Tätigkeit des "Beschaltens" eines Substrates ganz von einer Maschine übernommen werden.

Diese Maschine ist ebenfalls Gegenstand der Erfindung.

Die Hauptproblematik liegt jedoch im optimalen Umgang mit der Vielzahl von Verschaltungs-Möglichkeiten zusammen mit einem möglichst simultan ablaufenden Realisierungsvorgang. Es ist daher die Aufgabe der Erfindung ein Verfahren anzugeben, mit welchem ein Universalsubstrat schaltungstechnisch sowie ausführungstechnisch optimal genützt werden kann. Beide Funktionen, Schaltungsvorbereitung und Ausführung mit Maschinensteuerung greifen eng ineinander.

Einleitend einige Worte zum verfahrensmässigen Vorgehen ganz generell. Früher wurden die universellen Schaltungssubstrate bspw. in der Wire-Wrap-Technik realisiert. Diese Art Wiring-Technik bediente sich jeweils so vieler Schaltungs-Ebenen, wie benötigt wurden, um die gewünschten Verbindungen herzustellen. Das Ziel war stets, elektrische Verbindungen zwischen 2 (oder mehr) Punkten ohne Kurzschlüsse mit den übrigen Verbindungen herzustellen. Grundsätzlich hat sich daran nichts geändert, es ist auch heute noch das Ziel, kurzschlussfreie elektrische Verbindungen zwischen 2 (oder mehr) Punkten herzustellen, also ein elektrisches Wiring durchzuführen, nur dass im vorliegenden Falle die "wires" schon vorhanden sind und auf ihre eigene Art miteinander verbunden werden sollen. Die systematische Anlage von vorgegebenen Kontaktierpunkten verhindert jedoch, bisher bekannte Wiring-Techniken direkt oder modifiziert zu übernehmen. Es ist vielmehr nötig eine neue Wiring-Technik anzuwenden, die nun Gegenstand der nachfolgenden Diskussion ist.

Topologisch betrachtet weist ein Universalsubstrat durch seine veränderbaren Schaltstellen bezüglich der vorhandenen und realisierbaren Verbindungen ein gewisses Veränderungspotential auf. Bevor ein einziger Kontakt realisiert wurde, ist das Schaltstellen-Veränderungspotential, kurz Veränderungspotential genannt, maximal. Die Grösse dieses Veränderungspotentials ist nur vom Bauplan des Substrates abhängig. Ist der Bauplan festgelegt, so ist auch das obere Schaltstellen-Grenzpotential (max) gegeben. Mit jeder irreversiblen Schaltstellenveränderung nimmt das Veränderungspotential ab bis zum unteren Schaltstellen-Grenzpotential (min) von Null. Die Menge aller Möglichkeiten, einen gegebenen elektrischen Schaltungsplan (eine Applikation) auf dem Substrat zu realisieren, ist das Applikations- oder Nutzpotential, das natürlich zwischen dem oberen und unteren Schaltstellen-Grenzpotential liegt. Das Applikationspotential kann im günstigen Fall nahe an das Grenzpotential heranreichen und im ungünstigen Fall sehr klein sein. Das unnützbare Potential von im jeweils speziellen Fall "nicht verwendbarern" Schaltstellen ist das Schaltstellen-Verlustpotential. Das Schaltstellen-Grenzpotential als Menge machbarer Schaltungen (Menge der maximal nutzbaren Schaltstellen) beinhaltet das Schaltstellen-Applikationspotential als Menge nutzbarer Schaltungen für die gegebene Applikation (Menge nutzbarer Schaltstellen). Die Differenz, also die Menge der nicht nutzbaren Schaltungen (bzw. Schaltstellen) ergibt das Schaltstellen-Verlustpotential. Die wohl nutzbaren, aber für eine ausgewählte Realisierung nicht benötigten Schaltungen (bzw. Schaltstellen) ergeben das Schaltstellen-Korrekturpotential. Letzters ist eine sehr wichtige Grösse, denn sie erlaubt fabrikatorische und/oder konzeptionelle Beschaltungsfehler nachträglich zu korrigieren. Das Korrekturpotential ist eine Untermenge des Applikationspotentials. Liegen allerdings Substratdefekte oder Auslegungsfehler vor, so ergibt sich ein verändertes Veränderungs- oder/und Applikationspotential und das Korrekturpotential kann in den Bereich des vormaligen Verlustpotentials reichen. Dies ist also die Welt, mit der man leben muss. Wie man darin ordentlich zurecht kommt, wird nun anschliessend unter Zuhilfenahme der nachfolgend aufgeführten Figuren eingehend diskutiert.

Es zeigen :

Figur 1A und 1B eine bildhafte Darstellung der Schaltstellen-Potentialbetrachtung in termini der Mengenlehre.

Figur 2 eine schematische Darstellung der wesentlichen Teile im Prozessablauf beim Kontaktieren eines Universalsubstrates, welche gleichzeitig die wesentlichen Vorrichtungsteile einer Mikrokontaktiervorrichtung darstellen.

Figur 3A 3B 3C ein Flussdiagramm als Beispiel einer von mehreren möglichen Vorgehensweisen.

Figur 4 eine Vorrichtung (abgeleitet aus Figur 2) zur Mikrokontaktierung und Mikromessung von Universalsubstraten.

Figur 5 das Prinzip eines mechanischen Multi-Mikrokontaktierers bzw. eines Multi-Mikroprüfkopfes.

Figur 6A 6B 6C einen ersten Kontaktiervorgang.

Figur 7A 7B 7C einen zweiten Kontaktiervorgang.

Figur 8A 8B 8C einen dritten Kontaktiervorgang.

Figur 9 ein Leitungsmuster eines Universalsubstrates, wie es für den Kontaktiervorgang gemäss Erfindung als Beispiel zugrunde gelegt wird.

Figur 10 das Leitungsmuster gemäss Figur 9 modular weitergeführt, um zu zeigen, dass das Verfahren auf Leitungsmuster beliebiger Grösse innerhalb der Substratabmessung angewendet werden kann.

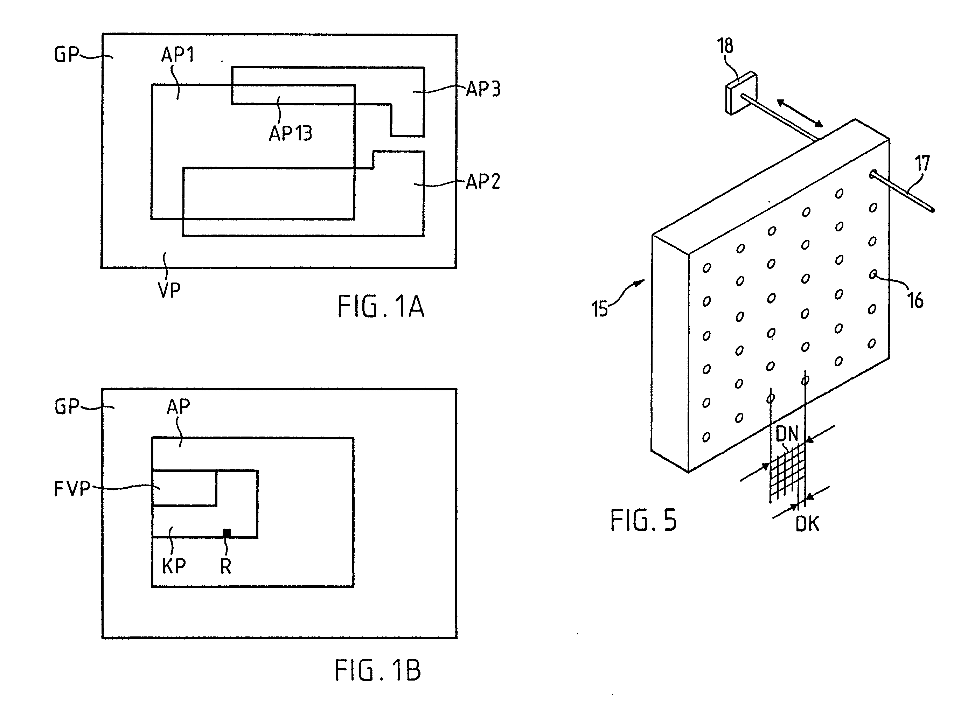

Wie schon in der Einleitung skizziert, muss vor der Verwendung eines Universalsubstrates und der darauf zu realisierenden elektrischen Schaltung eine Schaltstellen-Potentialbetrachtung angestellt werden. Die Zuordnung von Schaltstellen folgt als nächster Schritt. Figur 1A zeigt in Form eines Rechtecks als Menge gezeichnet das Veränderungspotential eines bestimmten Substrats, hier sein Grenzpotential GP. Dies kann lediglich einen Teil oder Ausschnitt des Substrates betreffen, wenn bspw. für eine bestimmte von mehreren Schaltungen auf demselben Substrat das Applikationspotential freigelegt werden muss, oder es betrifft das ganze Substrat, wenn nur eine einzige Schaltung auf dem Substrat realisiert wird. In diese das GP darstellende Menge sind die als Mengen dargestellten Potentiale dreier verschiedener Applikationen AP1, AP2, AP3 eingezeichnet. Die Restmenge stellt das Verlustpotential VP dar. Man muss sich dabei im Klaren sein, dass diese Potentiale jeweils die kombinatorische Anzahl der Möglichkeiten darstellen, aus den Schaltstellen Schaltungen zu realisieren und nicht die Anzahl Schaltstellen selbst, wie sie auf dem Substrat physisch vorhanden sind.

Man sieht nun, dass die Applikation 1 mehr Möglichkeiten (AP1) zur Realisierung der Schaltung auf dem Substrat hat, als die beiden anderen Applikationen. Die Applikation 2 ist eingeschränkter, obwohl auf dem Substrat gleich viel Schaltstellen vorhanden sind, wie für die Applikation 1, bei der Applikation 3 ist dies noch ausgeprägter. Die Gründe sind bspw. mehr Verbindungen, ungünstiger Verdrahtungsverlauf (Kreuzungen), Schaltungsverschachtelung und so fort, alles ungünstige Bedingungen im Zusammenhang mit der Verdrahtung auf einem Universalsubstrat. Ferner erkennt man aus der Ueberlappung, dass zwar die Applikationen 1 mit jeder der beiden anderen auf ein und demselben Substrat realisierbar ist, aber nicht mit beiden gleichzeitig, ja nicht einmal die Applikationen 2 und 3 sind untereinander realisierbar. Für eine gleichzeitige Realisierung von Applikation 1 und Applikation 3 auf demselben Substrat resultiert das Applikationspotential AP13.

Die Auswahl der zu realisierenden Schaltung aus der Vielzahl gegebener Möglichkeiten erfolgt nach einem Optimierungskriterium, welches Faktoren gewichtet wie beispielsweise Flächenbedarf, Anzahl Kontakte, Ueberlappung verschiedener Applikationen (gegenseitige Beeinflussung) Leitungslängen und anderes mehr. Ein wichtiger Aspekt ist dabei auch das verbleibende Korrekturpotential. Jede Realisierung verringert auf ihre Weise das Veränderungspotential und das Applikationspotential, weil ein an einer bestimmten Stelle hergestellter Kontakt eine Anzahl von anderen Lösungen verunmöglicht. Das gegenüber vor der Realisierung eingeschränkte, noch verbleibende Applikationspotential ist das Korrekturpotential, das ebenfalls in die Optimierung einbezogen werden kann. Zu korrigieren gibt es allerdings erst dann etwas, wenn eine Realisierung sich als fehlerhaft herausstellen sollte. Dabei ist davon auszugehen, dass eine an vorgesehener Stelle nicht oder unerwünschterweise zu Stande gekommene Verbindung oder Trennung nicht zuverlässig verwendbar oder heilbar ist und daher nicht benutzt werden soll. Ein Fehler wird also das Korrekturpotential immer weiter vermindern (u.U. drastisch, wenn es bei der Fehlerstelle um eine schaltungstechnische Schlüsselstelle handelt).

Fig. 1B zeigt bildlich diesen Vorgang anhand des Mengendiagramms. Ausgehend vom Grenzpotential GP mit einer Applikation mit dem Nutzpotential AP bewirkt die Realisierung R ein Schrumpfen des Applikationspotentials AP auf das Korrekturpotential KP, welches seinerseits noch vermindert ist um das zusätzliche, fehlerbedingte Verlustpotential FVP. Während der Bearbeitung (Wiring) der Substrate kann das fehlerhafte Substrat wieder rückgeführt werden, um einer Nachkontaktierung unterzogen zu werden. Dies ist aber nur dann möglich, wenn ein genügend grosses Korrekturpotential vorhanden ist.

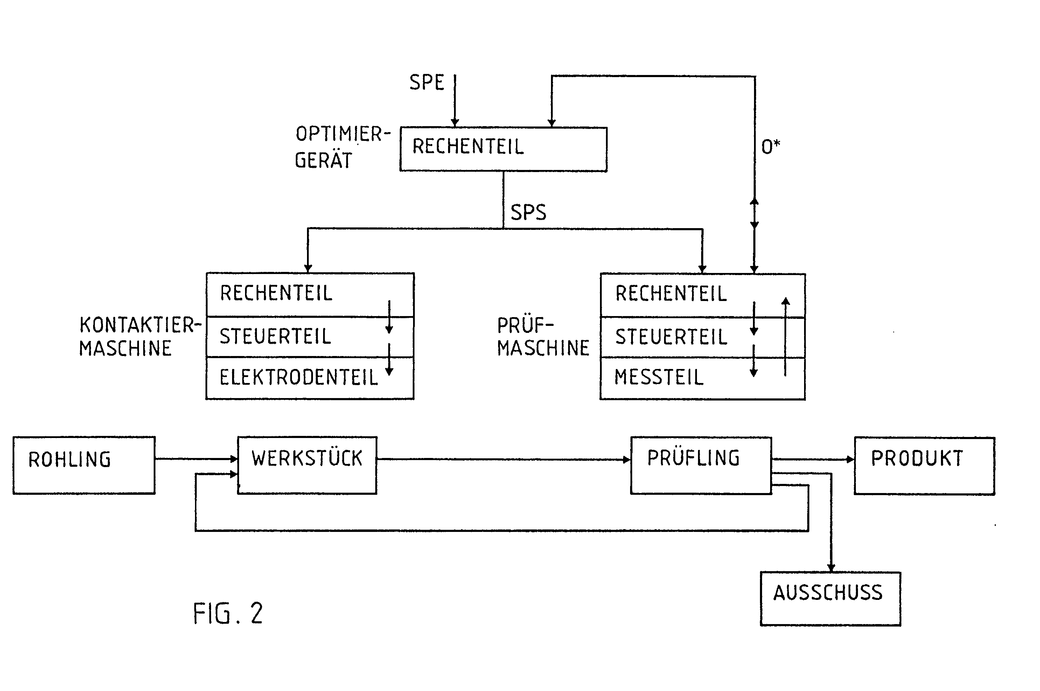

Figur 2 zeigt nun ebenso schematisch wie Figur 1 einen Prozessdurchlauf eines Universalsubstrates, das auf der linken Seite als Vorprodukt (Rohling) in den Prozess eingeschleust wird und ihn auf der rechten Seite als kundenspezifisches Produkt mit der eingeprägten Applikation verlässt. Die völlig unverdrahteten Substrate werden in einer Kontaktiermaschine oder -vorrichtung vorverdrahtet (die Endverdrahtung erfolgt durch das Aufbonden der Schaltungselemente), das heisst, sie werden physikalisch behandelt und anschliessend an eine Prüfvorrichtung weitergegeben. In der Prüfvorrichtung wird das Substrat ausgemessen und auf die Vorgaben, das ist der Verdrahtungsplan, aus dem Rechner geprüft. Werden die Vorgaben erfüllt, wird das Substrat als "gut" weitergegeben. Werden die Vorgaben nicht erfüllt, wird das Korrekturpotential ermittelt und in Bezug zu den nötigen Korrekturen, also zu den elektrischen Ersatzpfaden, gebracht. Werden diese Kriterien positiv erfüllt, das heisst, es hat noch Möglichkeit für elektrische Ersatzwege, so wird das Substrat rückgeführt und wieder in die Kontaktiervorrichtung zur Nachbearbeitung gegeben. Werden diese Kriterien jedoch negativ erfüllt, so wird das Substrat in den Ausschuss gegeben, wo es allerdings immer noch nicht ganz unbrauchbar sein muss.

Das faktische Korrekturpotential ergibt sich in der Regel erst, wenn der Fehler vorliegt. Ist der Fehler durch die Prüfvorrichtung festgestellt, bspw. eine ungenügend ausgebildetet Kontaktstelle, so muss der Rechner seinerseits feststellen, ob unter allen verbleibenden Schaltungsmöglichkeiten noch ein "Pfad" besteht, der die Fehlerstelle funktionell kompensieren kann. Dies können unter Umständen mehr als ein Pfad, also mehrere Pfade, die aus den Schwierigkeiten führen, sein. Falls dem so ist, wird ein genügend grosses Korrekturpotential gemeldet und das Substrat, das ja an sich ein eher teures Bauelement ist, wird wieder in den Prozess rückgeführt. Falls im Falle mehrerer Möglichkeiten (Pfade) die Korrekturkontaktierung auch versagen würde, so käme dieses Substrat ein drittes Mal in die Kontaktier- bzw. Verdrahtungsmaschine.

Die Kontaktiermaschine, die später bei der Diskussion der Vorrichtung näher erläutert wird, arbeitet bspw. mit einem Laser zum Trennen oder Schweissen oder mit einer Mikrokontakt-Schweisseinrichtung oder kombiniert mit beidem. Abgesehen von diesen beiden Kontaktiervorgehen, kann mit diesem Verfahren auch eine Kontaktierung mittels elektrisch leitender Materialien bspw. Klebstoff zwischen zwei Leitern durchgeführt werden. Dazu muss die Vorrichtung entsprechend ausgestaltet werden.

Die Kontaktiermaschine kann die Kontaktierung simultan oder sequentiell, parallel oder seriell oder in Mischformen durchführen. Kontaktiert wird nach Schaltplan. Dabei unterscheidet man zwischen dem Schaltplan der elektronischen Verbindungen SPE, dem Schaltplan für das Substrat SPS (das eigentliche Wiring) und dem "Schaltplan" für die Elektrodensteuerung SPK in der Kontaktiermaschine. Aus dem SPE ergibt sich der SPS und daraus wird dann der SPK hergeleitet. Das erfinderische Verfahren vermittelt zwischen der SPE-Topographie und der SPK-Elektrodensteuerung und in einem zusätzlichen Schritt noch zur Transporteinrichtung für das Material, das in der Maschine bearbeitet wird.

Wird zum Kontaktieren und/oder Trennen eine Laserschweissung zur Kontaktbildung bzw. zur Leiterunterbrechung benötigt, so wird die Vorrichtung wahrscheinlich seriell arbeiten können und trotzdem vertretbare Prozessgeschwindigkeiten erreichen können, da die Lasersteuerung sehr rasch arbeitet. Wird eine Mikrokontaktschweissung (bspw. mittels Ultraschall oder Kaltschweissung mit Druck) benötigt, was jeweils vom Typ des Substrats abhängt, so wird zumindest eine teilparallele Vorgehensweise erwünscht sein. Für das Trennen von Leiterbahnen würde dann ein Trennlaser verwendet, der das Trennmuster realisiert.

Universalsubstrate weisen eine regelmässige (koordinatenbezogene) Anordnung von Kontaktstellen auf, sodass Multischweissköpfe mit Arrays von bspw. 10 mal 10 Schweiss-Stellen oder 20 mal 40 Schweiss-Stellen gebaut und verwendet werden können. Nebst der Positionierroutine, die den Multischweisskopf in die gewünschte Position bringt, muss auch eine (n aus m - Auswahl) n = Anzahl momentan zu verschweissender Kontaktstellen, m = Anzahl der Schweiss-Stellen des verwendeten Multischweisskopfes getroffen werden. Auf diese Weise lässt sich bei einem einmaligen Konstruktionsaufwand für den Multi-Schweisskopf die Prozessgeschwindigkeit beträchtlich erhöhen.

Das Verfahren vermittelt, wie gesagt, zwischen dem SPE und SPK und umfasst in einem zusätzlichen Verfahrensschritt auch einen Operator O*, der zwischen der Kontaktiermaschine und der Prüfstation vermittelt. Er hat folgende Aufgaben zu verrichten : er verknüpft die Prüfresultate mit den Verdrahtungsvorgaben und legt das faktische Korrekturpotential frei oder zumindest hilft er das Korrekturpotential freizulegen, er legt die Neuoptimierung fest und er ermittelt ein allfälliges Restkorrekturpotential. Somit ist dieser Operator O* zuständig für die Neuoptimierung einer Verdrahtung des schon bearbeiteten Universalsubstrates. Er wirkt im Bearbeitungs-Prozess derart, dass beim einmaligen Durchlauf eines Substrats eine virtuelle Nachoptimierung geschieht, also das Korrekturpotential nicht verwendet wird, bzw. beim Mehrmalsdurchlauf eine reelle Nachoptimierung geschieht und damit das Korrekturpotential verwendet wird. Er läuft stets mit und flankiert den Prozess bezüglich Fehlleistungen. Es ist jedoch nicht nötig, dass für jedes einzelne Substrat, fehlerhaft oder nicht, stets das Korrekturpotential ermittelt wird. Die zu diesem Zweck vorgesehene Rechnung wird erst ausgelöst, wenn die Uebereinstimmung des Vorgabe-SPS mit dem geprüften (realisierten) SPS nicht gegeben ist.

Ist schliesslich das Korrekturpotential erschöpft, so kommt das Substrat in den Ausschuss oder es wird rekursiv (iterativ) einer anderen Applikation zugeführt. Es ist nämlich nicht gesagt, dass auf einem solchen Substrat nicht noch eine andere Schaltung ähnlicher Art Platz finden könnte, da ja, wie oben ausgeführt, zwischen den Applikationspotentialen beträchtliche Unterschiede bestehen können. Dies ist ein weiterer Vorteil des hier diskutierten Verfahrens, nämlich, dass (natürlich offline) Applikationen gesucht werden können, die in einem solchen Substrat, das lediglich ein vermindertes Grenzpotential aufweist, noch zu realisieren sind. Dies unter Umständen sogar noch mit dem gewünschten Korrekturpotential.

Wenn also das Substrat schon im Ausschuss ist, kann mit den ermittelten und vorhandenen Daten des Verdrahtungs-Prüflings offline nach einer weiteren Applikation gesucht werden, die auf dem "Restsubstrat" noch realisiert werden kann. Dies vermindert zusätzlich Verluste, was bei sehr teuren Substraten ganz sicher zum Tragen kommt.

Die schematische Darstellung von Fig. 2 zeigt getrennte Geräte für Optimierung, Kontaktierung (Wiring) und Prüfung. Es sind einerseits die wesentlichen Teile im Prozessablauf beim Kontaktieren eines Universalsubstrates und andererseits die wesentlichen Vorrichtungsteile einer Mikrokontaktiervorrichtung. Selbstverständlich können diese Funktionen teilweise oder ganz zusammengelegt sein. So können zum Beispiel die drei Rechenteile in einem gemeinsamen Rechner zusammengefasst sein, dessen Ausgang bzw. Ausgänge unter anderem die Steuersignale für den Steuerteil der Kontaktierelektroden oder der Messelektroden für den Prüfungsteil liefert. Es ist auch denkbar, dass ein und derselbe Kopfteil (z.B. ein Schlitten) sowohl die Kontaktier- als auch die Messelektroden trägt, das heisst, dass die Kontaktier- und die Prüfmaschine eine gemeinsame Koordinatensteuerung haben. Dabei kann die Kontaktierung eines Substrates (Werkstückes) und die Prüfung eines anderen Substrates (des vorangegangenen z.B.), das jetzt ein Prüfling ist, simultan erfolgen, wobei der SPK und der SPP ("Schaltplan" für die Prüfungssteuerung) gemeinsam abgefahren werden. Im Falle einer Kontaktierung durch Kaltschweissung, also mit Druck auf die Kontaktierelektroden, lassen sich diese ggf. gleich als Prüfelektroden verwenden. Damit wären Kontaktiermaschine und Prüfmaschine mechanisch weitgehend identisch, vom Verfahrensablauf hingegen, bleibt der in Figur 2 gezeigte Vorgang für jeden denkbaren Fall allgemein gültig.

Zusammengefasst sieht der Verfahrensverlauf im wesentlichen so aus :
- optimiertes Wiring festlegen, das die minimale Anzahl Kontaktierungen und die minimalen Leiterbahnlängen etc. ermittelt (Rechner)
- Steuerung des Mikrokontaktierwerkzeuges festlegen (Rechner)
- Positionierung der Elektroden durchführen (Steuerung)
- Verschweissung und/oder Trennung durchführen (physikalisch)
- Prüfvorgang ausführen (Messen und Rechnen)
- Entscheidung für gut, Ausschuss, Rückgabe (Rechner)
- Rückführung für neues Wiring (physikalisch)
- Neuoptimierung des Wiring festlegen (Rechner)
- Steuerung der Elektroden für die Korrektur festlegen (Rechner)
- Positionierung der Elektroden durchführen (Steuerung)
- Verschweissung und/oder Trennung für das Korrekturwiring durchführen (physikalisch)
- Nachprüfvorgang ausführen (Messen und Rechnen)
- Entscheidung für gut, Ausschuss, Rückgabe
- usf.

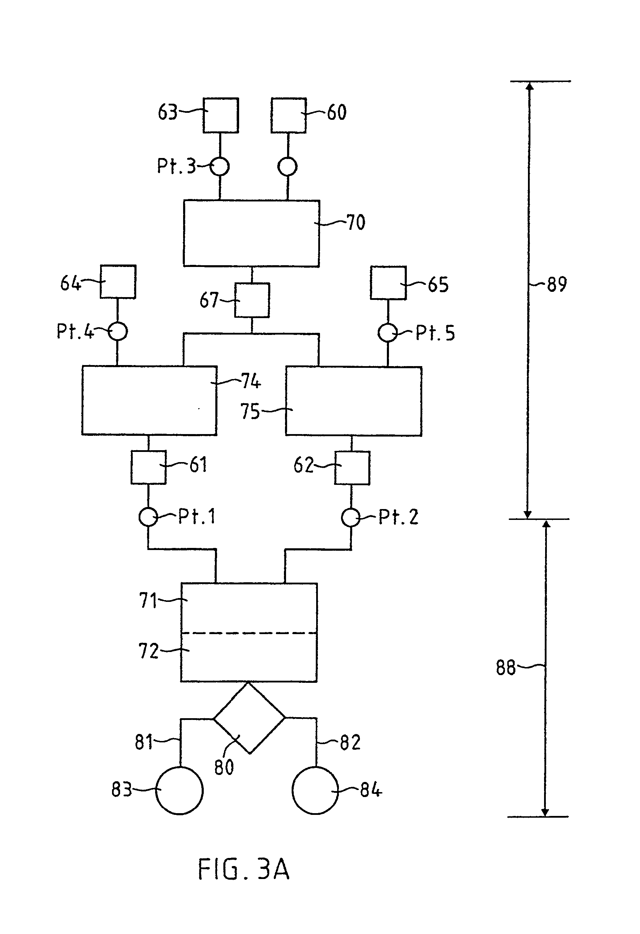

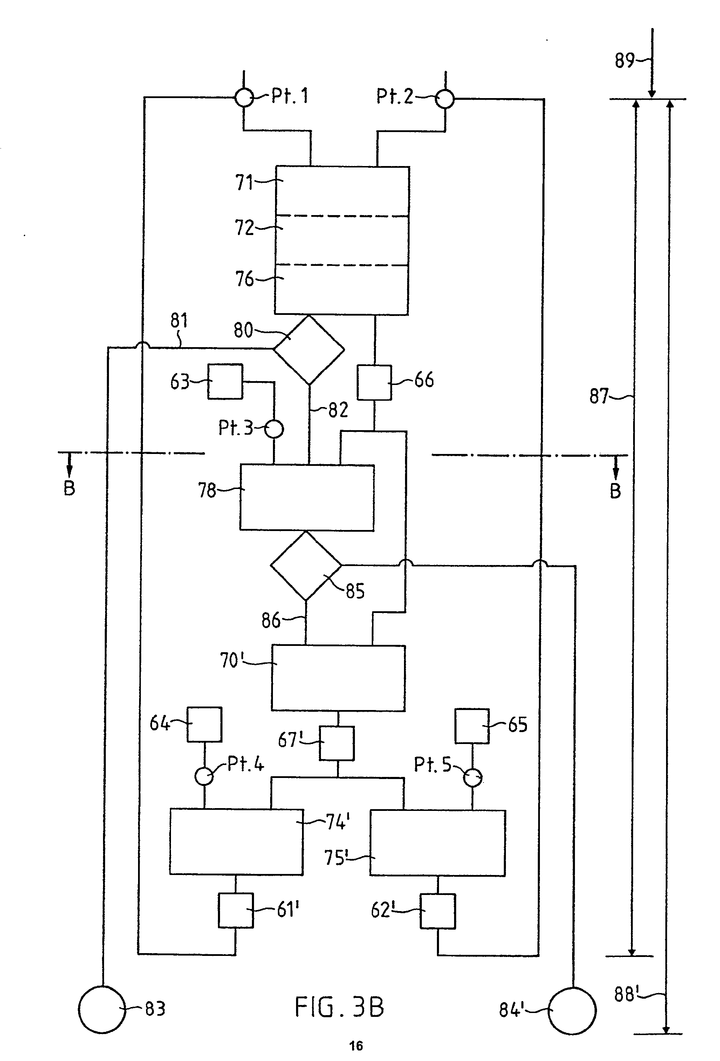

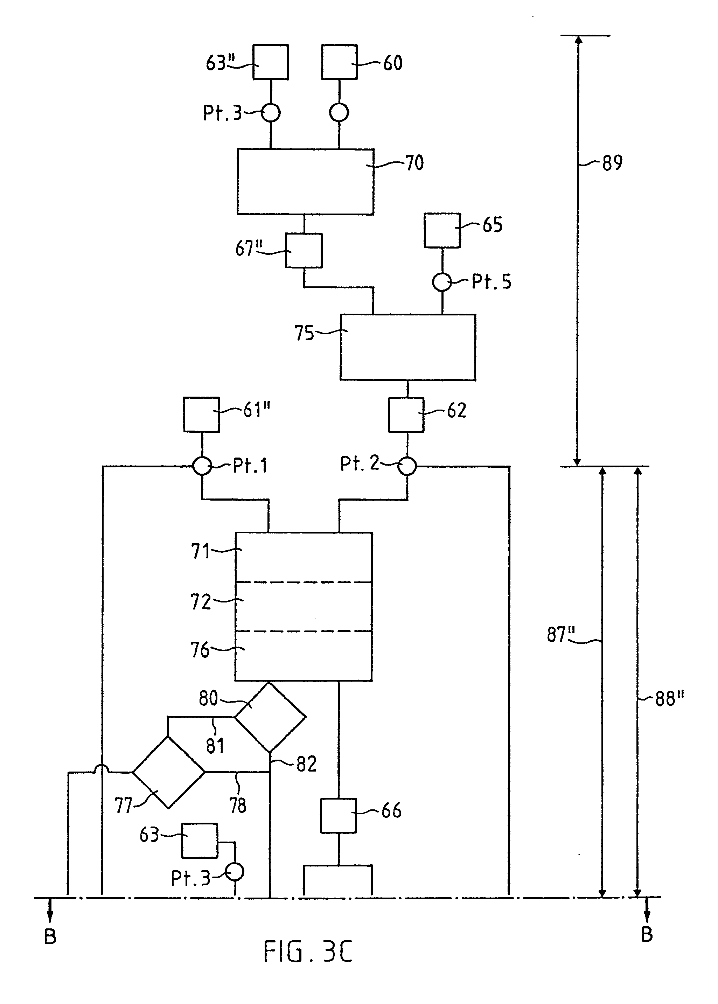

Die Figuren 3A, 3B und 3C zeigen den Verfahrensablauf mehr im Detail. In Figur 3A wird der Ablauf ohne die Substratrückführung bei einer Fehlverdrahtung dargestellt. In einem ersten Schritt wird mit Daten 63 des elektrischen Schaltplanes (Pt. 3) und mit Daten 60 des Universalsubstrates die optimale Verbindungsauslegung 70 berechnet. Hier geht man, so wie oben zum Thema der Möglichkeiten-Potentiale diskutiert, entsprechend vor.

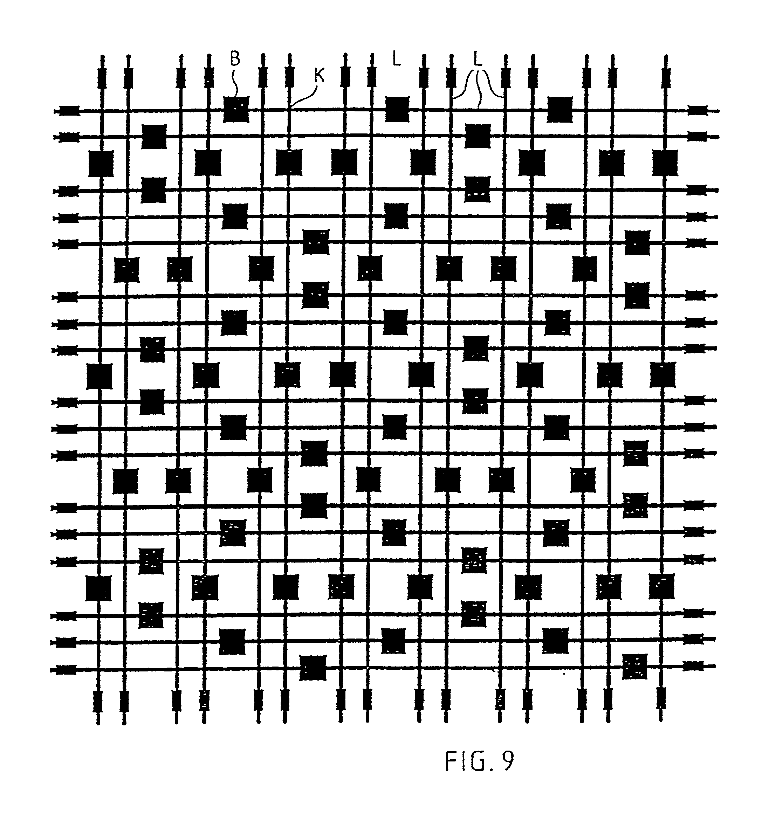

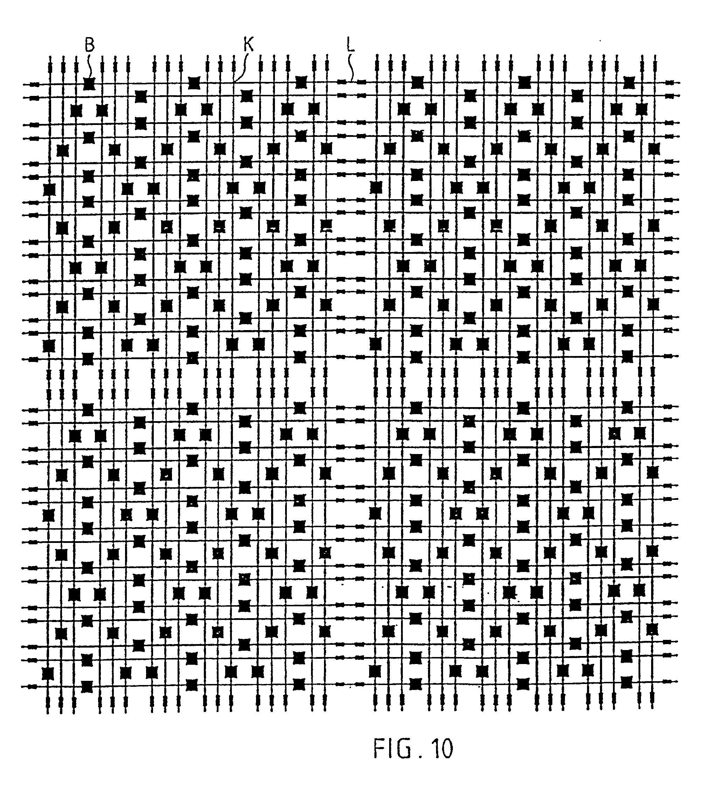

Für die Verbindungsauslegung wird der Einsatz eines CAD-Systems empfohlen. Es gibt im Zusammenhang mit solchen Systemen manuelle Router (Entflechtung von Hand) und Autorouter (automatische Entflechtung). Router sind Berechnungsprogramme für die Auslegung von Leiterplatten. Diese Programme gehen von ihrer Konzeption her davon aus, dass die Ebene, auf welcher die Leiterbahnen L anzubringen sind, völlig frei sind und Bahnen in jeglicher Richtung geführt werden können. Für eine optimale Verbindungsauslegung setzt man voraus, dass schon eine optimale Planung der Lage der Bauelemente unter Berücksichtigung von minimaler Fläche, minimale Verbindungen, kurze Verbindungswege und optimale thermische Wärmeabfuhr vorliegt. Beim optimalen Verbinden der Elemente über gekreuzte Kontaktpunkte K besteht bei den diskutierten Universalsubstraten (gegenüber durch zu kontaktierenden Leiterplatten) ein Freiheitsgrad derart, dass bei den plazierten Elementen noch nicht festgelegt werden muss, auf welche Bondflächen B des Substrats sie gebondet werden müssen (Figuren 9 und 10). Lediglich die Bedingung "keine Kreuzung der Bonddrähte" und "Bonddraht kürzer als 3 mm" müssen eingehalten sein. Nutzt man dieses Veränderungspotential aus, braucht der Router eine entsprechende Ergänzung, da (im diskutierten Beispiel) nur rechtwinklige Richtungsänderungen sinnvoll sind. Für Bahnen, die im Grundraster nicht benützt werden, oder besser, nicht realisiert sind, ist dem Autorouter ein "Fahrverbot" aufzuerlegen. Dies sind einige wesentliche spezifische Randbedingungen für den einzusetzenden Autorouter (bspw. auf der Basis von Bartels-Router, Lee-Router etc. mit der entsprechenden Ergänzung). Anschliessend ist noch die minimierte Anzahl der Trennungen zwecks Maximierung des Korrekturpotentials zu ermitteln.

Die Daten 67 des anwendungsspezifischen Substratplans, das sind die Wiringdaten, werden einerseits einem Berechnungsvorgang 74 zur Ermittlung des optimalen Kontaktiervorgangs zugeführt, welcher dafür auch die Kenndaten 64 der Kontaktiervorrichtung (Pt. 4) benötigt. Ferner werden die Wiringdaten einem weiteren Berechnungsvorgang 75 zum Festlegen des Prüfungsvorganges zugeführt, welcher auch die Kenndaten 65 der Prüfvorrichtung (Pt. 5) benötigt. Aus den beiden Berechnungsvorgängen resultieren die Steuerdaten 61 für die Kontaktiervorrichtung (Pt. 1) und die Steuerdaten 62 für die Prüfvorrichtung (Pt. 2). Dies sind die geräte- und anwendungsspezifischen Vorbereitungshandlungen 89, die nur einmal für jede Anwendung durchzuführen sind.

Anschliessend kann die Kontaktierung 71 des unverdrahteten Substrates in der Kontaktiervorrichtung und die Prüfung 72 des verdrahteten Substrates in der Prüfvorrichtung durchgeführt werden. In der Prüfvorrichtung wird das Substrat ausgemessen und auf die Vorgaben, das ist der Verdrahtungsplan, aus dem Rechner geprüft (80). Werden die Vorgaben erfüllt (81), so wird das Substrat als brauchbar weitergegeben (83). Werden die Vorgaben nicht erfüllt (82) und ist keine Rückführung geplant, so kommt das Substrat in den Ausschuss (84). Diese Phase 88 wiederholt sich für jedes neu zu kontaktierende Substrat derselben Applikation.

Figur 3B zeigt den verfahrensmässigen Ablauf, für den Fall, dass eine Rückführung bei nicht erfüllten Vorgaben erfolgen muss. Nach einer identischen Initialisierung 89 und Kontaktierung 71 wie im Fall von Figur 3A, erfolgt bei der Prüfung 72 eine Auswertung 76 der bestehenden Verbindungen. Konkret gesagt: es wird festgehalten, welche Verbindungen korrekt hergestellt bestehen und welche schadhaft und daher nicht benutzbar sind. Von einem nach Kriterien gemäss Ablauf nach Figur 3A ausgeschiedenen Substrat, wird aufgrund der Daten 66 der aktuellen, realen Verbindungen das Korrekturpotential ausgenützt. In zweckmässiger aber nicht notwendiger Weise geschieht dies in zwei Stufen, wobei zunächst mit einfacheren Verfahren 78 festgestellt wird, ob überhaupt eine korrigierende Verbindungsauslegung möglich ist (85) und, falls das der Fall ist (86), die aufwendigere Optimierung 70′ unter Einbezug aller Kriterien durchgeführt wird. Diese Optimierung 70′ hat jetzt natürlich von den Daten 66 des realen, aktuellen Substrats auszugehen, und nicht mehr, wie bei der Initialisierung 89, von den Daten des idealen, nichtkontaktierten Substrats.

Die Optimierung 70′ liefert die Daten 67′ des korrigierten Substratplanes bzw. der durchzuführenden Korrekturkontaktierungen. Daraus wird einerseits, zusammen mit den Kenndaten 64 der Kontaktiervorrichtung (Pt. 4) der optimale (Korrektur-)Kontaktiervorgang 74′ und andererseits zusammen mit den Kenndaten 65 der Prüfvorrichtung (Pt. 5) der Prüfungsvorgang 75′ berechnet und mit den entsprechenden Daten 61′, 62′ zum Kontaktieren und Prüfen zurückgekehrt. Dieser "innere Zyklus" 87 kann sich, wie schon früher erwähnt, wiederholen, falls wieder ein Kontaktierfehler bzw. Verdrahtungsfehler aufgetreten ist und das Korrekturpotential noch nicht erschöpft ist.

In einer anderen Verfahrensvariante zur Rückführung des Substrates, welche jedes Substrat schon zu Beginn als Individuum behandelt, ohne ein bestimmtes Verbindungspotential vorauszusetzen, wird im Normalfall wohl zu viel Rechenaufwand erfordern, aber im Spezialfall, insbesondere beim Verwenden von für eine vormalige Applikation ausgeschiedenen Substraten, kann es angezeigt sein, so vorzugehen. Dies zeigt Figur 3C.

In der Diskussion wurde zwischen zwei Stufen der Korrekturpotential-Ermittlung unterschieden. In der einen Variante werden alle durch die Applikation abgedeckten Flächen als Sperrgebiete betrachtet und eine neue Verbindung zwischen peripheren Kontaktierpunkten wird berechnet. In der anderen Variante werden alle durch die Applikation belegten Leiterstücke (inklusive der fehlerhaften) als belegt erklärt und der Router sucht die neue Verbindung aus dem Restpotential von Verbindungsmöglichkeiten. Dies gilt auch für Trennstellen: ist bspw. der Defekt ein Kurzschluss, also eine fehlende Trennung, so muss entlang des "ungetrennten" Abschnittes eine weitere Trennstelle liegen, die sich öffnen lässt. Hat es eine solche nicht, muss diese fehlerhafte Verbindung als belegt erklärt werden und der Router muss eine neue Verbindung suchen, mit welcher dieses fehlerhafte Leiterteil ausgeschlossen werden kann. Umgehungen von fehlerhaften Teilen sind bspw. durch eine mäanderartige oder parallele Leiterführung zu realisieren. Den optimalen Korrektur-Layout erhält man durch einen iterativen Router-Algorythmus, der nach den verschiedenen Kriterien mit verschiedenen Prioritäten optimiert. Hier sind dann die Grenzbedingung folgende : Beibehaltung möglichst aller Verbindungen bis auf die geänderte und suchen einer alternativen Verbindung oder Neuberechnung aller Verbindungen unter Berücksichtigung der neuen Parameter. Bei oberster wirtschaftlicher Priorität ist die erste Grenzbedingung anzustreben.

Die Initialisierung 89" ist gegenüber den vorher erläuterten Varianten vereinfacht. An Stelle der Daten 63 des gewünschten elektrischen Schaltplans werden die Verbindungen des idealen Substrates als Daten 63" des elektrischen Schaltplans vorgegeben. Die Berechnung 70 der optimalen Verbindungsauslegung wird damit äusserst einfach und führt auf die Daten 67" des universellen Substratplans. Würde aufgrund dieser Daten 67" der Kontaktiervorgang berechnet, ergäbe sich die "Nullkontaktierung", das heisst, es braucht keine Verbindungsänderung vorgenommen zu werden. Dies wird durch die Daten 61" am Pt. 1 direkt eingegeben. Das Festlegen 75 des Prüfungsvorgangs wird wie bei den vorgängig beschriebenen Varianten bewerkstelligt und liefert die Steuerdaten 62 für die Prüfeinrichtung.

Im ersten Durchgang des inneren Zyklus 87" ist die Kontaktierung 71, also die "Nullkontaktierung", das heisst, es findet keine Kontaktierung statt. Handelt es sich beim Prüfling um ein unverbrauchtes defektfreies Exemplar, ergibt sich im Anschluss an das Prüfen 72 und Auswerten 76 beim Test 80, bei dem geprüft wird, ob das Substrat die erwarteten Verbindungen aufweist, ein positives Resultat (81). Damit darf aber das Exemplar natürlich noch nicht zu den brauchbaren Substraten 83 zugeordnet werden (es sei denn, man wolle nur die unverbrauchten Ausgangsubstrate auf Fehlerfreiheit prüfen). Es wird daher an einer gegenüber der Variante nach Figur 3B zusätzlichen Verzweigung 77 geprüft, ob es sich um den ersten Durchlauf handelt. Falls dem so ist (78), wird auf dem aus Figur 3B bekannten Verfahrenszweig weitergearbeitet und vom Schnitt B-B weg unterscheiden sich die Verfahren nicht mehr.

Diese Variante ist nur scheinbar weniger aufwendig, werden doch von jedem Substrat zunächst individuell die Daten 66 des aktuellen Substrats aufgenommen und in jedem Fall eine individuelle Berechnung 70' des optimalen Kontaktiervorgangs gemacht.

Selbstverständlich gilt dies nicht nur für den Vorgang des Kontaktierens, sondern auch für den Vorgang einer unter Umständen notwendigen Leiterbahntrennung, die gleichwertig in die Optimierung eingeht. Dazu wird, wie Eingangs schon erwähnt, ein Trennlaser oder eine andere Trennvorrichtung verwendet.

Das optimierte Wiring-Verfahren ermöglicht folgende Verbindungen bzw. Trennungen von Leiterbahnen, die in zwei, durch ein isolierendes Material getrennte Ebenen übereinander liegen :

Ist das isolierende Material gasförmig (Luft) so kann die Verbindung mittels eines Laserimpulses erfolgen, der so bemessen ist, dass sich eine der Leiterbahnen durch Erwärmung durchbiegt und die andere Leiterbahn berührt. Dazu kann der thermisch ausgebildete Kontakt durch einen mechanischen Niederhalter noch unterstützt werden. Ferner können mit einem ersten Laserimpuls die übereinanderliegenden Leiterbahnen durchbohrt und mit einem zweiten Laserimpuls mit grösserem Durchmesser zusammengeführt und verschweisst werden. Die Wirkung des Laserimpulses kann durch einen fokussierten Gasstrahl unterstützt werden, an Stelle eines mechanischen Niederhalters. Dieser Gasstrahl kann erhitzt sein, um die thermische Wirkung zu unterstützen.

In einer anderen Vorgehensweise werden die beiden übereinanderliegenden Leiterbahnen mit einem Laserstrahl durchbohrt und in die Bohrung ein elektrisch leitendes Medium eingebracht. Ein vorangehender Impuls kann dazu verwendet werden, die eine Leiterbahn so kollabieren zu lassen, bis sie die andere Leiterbahn berührt. Das elektrisch leitende Medium verbessert dann die Kontaktwirkung.

In einer weiteren Vorgehensweise kann mittels einer Kondensatorentladung über einer Leiterkreuzung eine Punktschweissung durchgeführt werden. Diese Entladung kann mittels zwei Elektroden oder mittels einer Elektrode und einer Leiterbahn als Elektrode durchgeführt werden.

In einer weiteren Vorgehensweise kann eine Kaltverschweissung der Leiterbahnen durchgeführt werden, in dem die eine Leiterbahn mit starkem Druck auf die andere Leiterbahn gedrückt wird. Diese Art Verschweissung kann unterstützt werden, in dem man beheizte Drucknadeln verwendet oder Drucknadeln mit Sonotrode.

In einer weiteren Vorgehensweise kann eine Verbindung mittels Microdispenser erfolgen, mit welchem die Leiterbahnen mittels eines elektrisch leitenden Materials verbunden werden. Beim Substrat gemäss dem oben genannten Europäischen Patent wird das Polyamidfenster bspw. mit Gold oder Silber enthaltendem Harz, bspw. Epoxyharz, aufgefüllt. Der Mikrodispenser kann ähnlich wie ein Tintenstrahl-Sprühkopf aufgebaut sein, sodass er wie ein Multischweisskopf wirkt.

In einer weiteren Vorgehensweise kann die Verbindung von Leiterbahnen auch galvanische erfolgen, in dem in einem Galvanobad die Leiter unter gegenpoligen Strom gesetzt werden, deren Kreuzung verbunden werden soll.

Das Trennen der Leiterbahnen erfolgt bspw. durch einen Laserimpuls, der so beschaffen sein soll, dass er die Umgebung nicht aufwärmt, sondern lediglich lokal ein Leiterbahnstück verdampft.

Es werden hier Beispiele von Laserwiring oder laserunterstützem Wiring deshalb gegeben, weil mit Lasern sehr gezielt und schnell gearbeitet werden kann. So sind auf dem diskutierten Substrattyp Laserimpulse von 10 bis 30 Mikrometer Durchmesser zu verwenden, was mit mechanischen Mitteln allein schon recht schwierig ist. Jedoch ist das Wiring mit mechanischen Mitteln trotzdem eine Alternative, insbesondere dann, wenn ein Multimikrokontaktier-Kopf, ähnlich wie ein Matrix-Druckkopf, verwendet wird, mit welchem sich sehr rasch ganze Felder einer Substratmatrix mit nur einer Positionierbewegung simultan kontaktieren lassen.

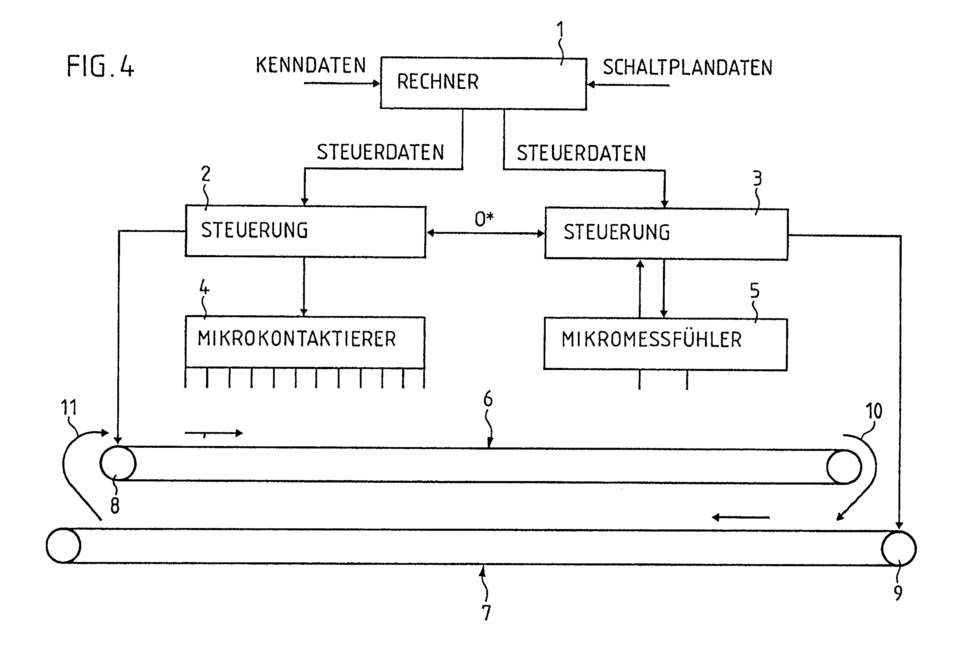

Figur 4 zeigt nun ganz schematisch eine Vorrichtung, mit welcher der oben diskutierte Prozess ausgeführt werden kann. In einem Rechner 1, der die Kenndaten für die Steuerungen und die Schaltplandaten erhält, rechnet die Verdrahtungsoptimierung des Universalsubstrates durch und setzt sie in Steuerdaten für die Steuerung 2 des Mikrokontaktierers 4 und die Steuerung 3 für das Prüfgerät mit dem Mikromessfühler 5 um, mit welchen Daten diese beiden Geräte über dem Substrat positioniert werden und der Mikrokontaktierkopf betrieben bzw. die Messdaten kollektioniert werden. Zwei Transporteinrichtungen 6 und 7 werden durch die Steuerung 2 der Mikrokontaktiervorrichtung und die Steuerung 3 der Prüvorrichtung gesteuert. Der Antrieb 8 der Transportvorrichtung 6, welche die Rohlinge der Kontaktierung zuführt und die programmierten Substrate der Prüfvorrichtung zuführt, ist hier durch die Steuerung 2 der Mikrokontaktiervorrichtung gesteuert und der Antrieb 9 der Transportvorrichtung 7, welcher Ausschuss-Substrate zur Korrekturkontaktierung rückführt, ist hier durch die Steuerung 3 der Prüfvorrichtung gesteuert. Die Uebergabe von Ausschuss-Substraten in die Rückführung und in die Neuverdrahtung ist hier mit zwei Pfeilen 10 und 11 angedeutet.

Die Mikrokontaktiervorrichtung 4 ist hier als Multimikrokontakter gezeichnet. Dies bezieht sich mehr auf die mechanische Einrichtung als auf einen Laser-Mikrokontakter. Es sollen jedoch alle adäquaten Mikrokontaktiervorgänge in das Verfahren einbindbar bzw. in der Vorrichtung realisierbar sein. Diskutiert wird nun in der Folge ein mechanischer Multimikrokontaktierer mit Nadeln zur Verformung der Kontaktbrücken und Verbindung zweier Leiter einer Kreuzung, mit welchem ein ganzer Array des Substrates praktisch simultan durchkontaktiert werden kann. Sind bspw. die Substrat-Matrizen im Modulo 100 hergestellt, das will heissen, dass eine Kantenlänge ein ganzes Vielfaches von 100 Kontakten aufweist, so wird ein Multimikrokontaktierer mindestens eine Reihe von 100 Kontaktiernadeln aufweisen. Damit können mit einer Positionierung bis zu 100 Kontaktkreuzungen programmiert werden. In der Regel wird man mehrere Reihen solcher Kontaktiernadeln in einem Multimikrokontaktierer zusammenfassen, wobei natürlich diese Nadeln nicht in der Dichte der Kreuzungspunkte angelegt sein müssen. Die Nadeldichte kann bspw. jeden fünften Kreuzungspunkt betreffen, sodass die Nadeln weiter auseinanderstehen. Hier entscheiden die mechanischen Kriterien, wie dicht die Nadelmatrix angelegt werden kann. Die einzelnen Nadeln sind axial bewegbar und sind einzeln angesteuert. Wird ein solcher Multimikrokontaktierer über dem Substrat so positioniert, dass die Nadelmatrix mit der Kreuzungsmatrix koinzidiert, derart, dass durch die Axialbewegung einzelner Nadeln die entsprechenden Kreuzungspunkte durchkontaktiert werden, so können auf einmal eine Mehrzahl von Kontakten geschaffen werden. Nach einer Neupositionierung werden jeweils die Nadeln aktiviert, deren zugeordneter Kreuzungspunkt kontaktiert werden soll.

Auf diese Weise kann auch ein Multi-Mikrodispenser gebaut werden, mit welchem sich elektrisch leitende Materialien in den Luftspalt zwischen den beiden Leitern einführen lassen. Ebenso ist ein Multi-Punktschweissgerät mit integrierter Elektrode realisierbar, bei dem stets die Elektroden aktiviert werden, deren zugeordneter Kreuzungspunkt kontaktiert werden soll. Die Gegenelektrode wird durch die Leiterbahn selber gebildet.

Solche Multi-Mikrokontaktierer werden, um wirtschaftlich zu arbeiten, Arrays von 100 mal 100 Kontaktierpunkten aufweisen, sodass in einem Positioniergang tausende von Kontakten gebildet werden können. Die Positionierung wird entsprechend derart optimiert, dass so wenig Positionierungen wie möglich durchgeführt werden müssen.

Eine solche Vorrichtung ist eine Alternative zu einem Laser-Mikrokontaktierer, der seriell, allerdings mit hoher Geschwindigkeit arbeitet. Welche Art von Kontaktierung gewünscht wird, mechanisch oder nichtmechanisch (mit Licht), hängt auch ein wenig vom Substrattyp ab. Jedenfalls ist der Aufwand für einen mechanischen Multimikrokontaktierer der diskutierten Grösse ungefähr im gleichen Rahmen, wie es der Aufwand für eine entsprechende Laseranlage ist. Auch der Programmieraufwand ist vergleichbar.

Der Operator O*, der zwischen der Kontaktiermaschine und der Prüfstation vermittelt, hat, wie weiter oben schon dargelegt, folgende Aufgaben zu verrichten : er verknüpft die Prüfresultate mit den Verdrahtungsvorgaben und legt das faktische Korrekturpotential frei oder zumindest hilft er das Korrekturpotential freizulegen, er legt die Neuoptimierung fest und er ermittelt ein allfälliges Restkorrekturpotential. Somit ist dieser Operator O* zuständig für die Neuoptimierung einer Verdrahtung des schon bearbeiteten Universalsubstrates. Er wirkt im Bearbeitungs-Prozess derart, dass beim einmaligen Durchlauf eines Substrats eine virtuelle Nachoptimierung geschieht, also das Korrekturpotential nicht verwendet wird, bzw. beim Mehrmalsdurchlauf eine reelle Nachoptimierung geschieht und damit das Korrekturpotential verwendet wird. Er läuft stets mit und flankiert den Prozess bezüglich Fehlleistungen. Es ist jedoch nicht nötig, dass für jedes einzelne Substrat, fehlerhaft oder nicht, stets das Korrekturpotential ermittelt wird. Die zu diesem Zweck vorgesehene Rechnung wird erst ausgelöst, wenn die Uebereinstimmung des Vorgabe-SPS mit dem geprüften (realisierten) SPS nicht gegeben ist. Für diesen Verfahrensteil ist der Rechner 1 zuständig, wobei solche Teilaufgaben auch je einem Rechnerteil in den beiden Einheiten zur Kontaktierung und Prüfung übertragen werden können.

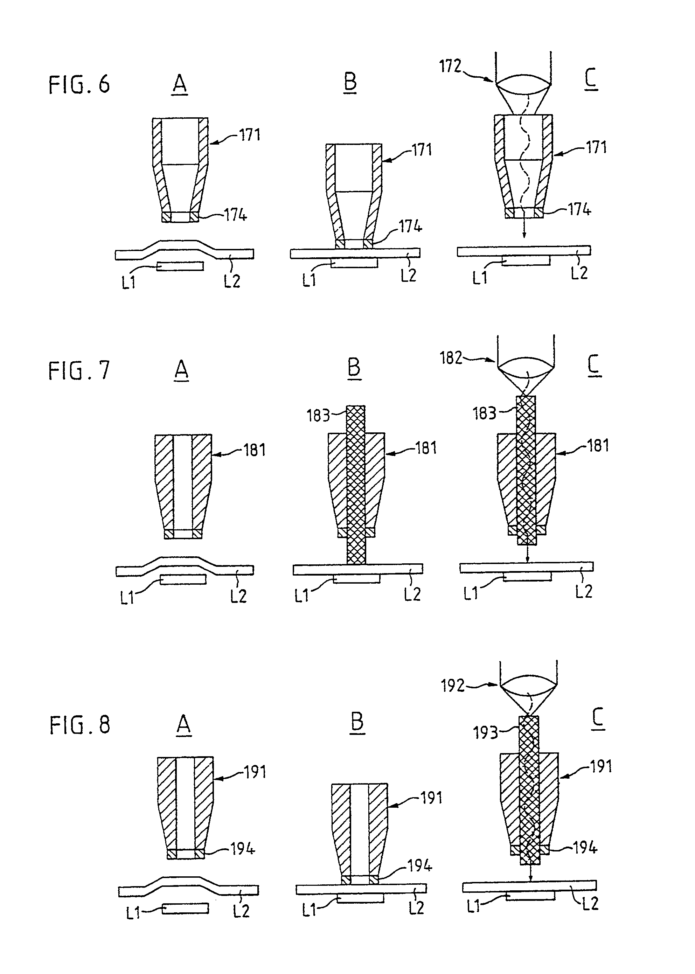

Figur 5 zeigt schematisch einen Multi-Mikrokontaktierer mit mechanischen Mitteln, welche Kontaktierlemente Nadeln oder Mikrodispensierer sein können. Ein Führungskörper trägt eine matrixähnliche Anordnung von Durchstichen 16, durch welche die Kontaktierelemente 17 geführt sind. Diese Kontaktierelemente sind axial bewegbar und werden von einem Antriebsmittel 18, bspw. ein Piezoelement gesteuert angetrieben. Die Durchstiche sind in einem Abstand DN angeordnet, der ein ganzzahliges Vielfaches des Kreuzungsabstandes DK des Substrates beträgt. Die Strekke DK stellt die Einheit der Positionierschritte dar, in welchen der Kontaktierkopf über dem Substrat positioniert wird. Bei einem Substrat, wie es in der genannten Patentschrift beschrieben ist, beträgt der orthogonale Abstand zwischen zwei Kreuzungen je nach Dichte 50 bis 100 Mikron. Diese Werte sind standardisiert und werden bei der Herstellung mit hoher Präzision eingehalten. Somit ist die Schrittlänge ein Zehntelmillimeter und darunter, was auch hohe Anforderungen an die mechanische Führung des Kontaktierers stellt, wenn man bedenkt, dass ein Substrat eine Kantenlänge von mehreren Zentimetern haben kann.

Es empfiehlt sich deshalb, einen Positioniersensor vorzusehen, mit welchem Korrekturen in der Positionierung derart möglich sind, dass sich Positionierfehler nicht addieren, sondern durch einen Regelungsvorgang stets eliminiert werden.

Die Prüfvorrichtung 5 ist in Figur als ein Prüf-Elektrodenpaar gezeigt. Damit soll angedeutet werden, dass grundsätzlich mit zwei Elektroden die Prüfung vorgenommen werden kann, wobei natürlich ein Multi-Prüfelektrodenkopf ähnliche Vorteile bringt, wie ein Multimikrokontaktierer. Ein Multiprüfelektrodenkopf kann prinzipiell gleich aufgebaut sein, wie der Multi-Mikrokontaktierer, so dass durch Positionierungen und Aufsetzen von bestimmten Messelektrodenkopf

den aus einer Vielzahl von Messelektroden an den vorbestimmten Messpunkten gemessen werden kann. Auch hier ist ein Positioniersensor empfehlenswert, da ähnliche Anforderungen wie beim Kontaktierer auch an den Prüfkopf gestellt werden, obwohl die Prüfstellen im Regelfall peripher am Substrat angebracht und unter Umständen grossflächiger ausgebildet sind, um den Prüfungsaufwand in Grenzen zu halten.

Ferner kann, ganz prinzipiell betrachtet, durch Funktionsumschaltung ein Multimikrokontaktierer als Multimikroprüfer verwendet werden, da die Matrix ja immer dieselbe bleibt. Solche Vorrichtungen dienen dann zum Programmieren von Universalsubstraten, die jeweils das gleiche Matrixmodul aufweisen, was ja durchaus angestrebt wird.

Der oder die Kontaktier-/Prüfköpfe werden bspw. auf einem Kreuzschlitten befestigt, mit welchem die Positionierung ausgeführt wird. Die Werkstücke, das sind die zu programmierenden Substrate, werden auf der Transporteinrichtung zugeführt und für den Programmier-/Prüfprozess angehalten. Je nach Prüfresultat wird das programmierte Substrat zurückgeführt und neu als Werkstück einer Nachkontaktierung unterzogen. Die Transporteinrichtung ist hier schematisch als Band gezeichnet, wobei es auch ein Roboter sein kann, der das Werkstück vorlegt und es auch eine gesteuerte Unterlage sein kann, die die Positionierschritte ausführt, wobei der Kontaktier- und/oder Prüfkopf mit den Zuleitungen festmontiert ist. Dabei wird bei angehobenen Nadeln die entsprechende Positionierung, was einer zur Nadelmatrix relativen Horizontalbewegung entspricht, durchgeführt und anschliessend die Kontaktierbewegung orthogonal dazu durchgeführt. Wird dieser Vorgang "über Kopf" ausgeführt, so kann als zusätzliches Sicherheitselement das Eigengewicht der Nadeln zur Entkopplung vom Substrat eingesetzt werden. Dazu wird ein Roboterhandling empfohlen, bei dem das Substrat auf einen Kreuztisch aufgelegt wird und dieser um 180 grad gedreht und mit dem Substrat nach unten über den Kontaktier- oder Prüfkopf geschwenkt und mit einer kurzhubigen Senkbewegung in die erste Position gebracht wird.

Da die Mikrokontaktierung doch einige Minuten dauern kann, ist die durch ein Roboterhandling verlängerte Rüstzeit vertretbar. Um die Rüstzeit zu verringern, kann mit alternierend beschickten Kreuztischen eine Vorbereitungshandlung eingeführt werden, mit welcher die Rüstzeit praktisch halbiert werden kann.

Details aus einer Kontaktiervorrichtung, mit denen auch drei Beispiele eines Kontaktiervorganges an einem Kontaktierpunkt gezeigt werden, sind in den Figuren 6, 7 und 8 dargestellt. Jede Figurengruppe zeigt drei Zustände A, B, C bedeutend, Ausgangslage A, Kontaktiervorgang B und nachträgliches (fakultatives) Verschweissen C.

Die Teile 71, 81, 91 sind Hohlführungen, mit dem Ziel, durch die innere Oeffnung Energie zur eventuellen nachträglichen Verschweissung durchführen zu können. Dazu dient eine Laserquelle 72, 82, 92. Die Laserenergie wird entweder direkt durch den Hohlraum oder über einen Lichtleiter 83, 93 auf die zuvor mechanisch kontaktierten Leiter $L_1$ und $L_2$ gebracht. Für die mechanische Kontaktierung weist eine Hohlführung einen Kontaktierring 74, 94 auf, der auf die allerdings geringe mechanische Belastung ausgelegt ist.

Der erste Schritt A zeigt die Ausgangslage. Die beiden gekreuzten Leiter sind durch spezielle Formgebung voneinander beabstandet, das heisst durch eine Luftbrücke voneinander isoliert. Diese Isolierung wird hier durch das Aufpressen des oberen Leiters $L_2$ auf den unteren Leiter $L_1$ aufgehoben und eine galvanische Verbindung erzielt. Das Aufpressen zeigt der zweite Schritt B. In Figur 6 und Figur 8 wird mit der Führung 71, 91 bzw. dem Kontaktring 74, 94 gepresst, in Figur 8 mit dem Lichtleiter 83, der durch die Führung geschoben wird. Da nur geringe Kräfte zur Verformung der Leiterbrücken nötig sind, können bekannte Lichtleitermaterialien bzw. Lichtleiter zur Anwendung kommen.

Mit einer solchen galvanischen Verbindung ist das Ziel, einen Kontakt zwischen zwei übereinanderliegenden Leiterbahnen zu schaffen, erreicht. Nun hat man die Wahl, in einem weiteren Schritt C eine nachträgliche Verschweissung durchzuführen. Dazu wird ein entsprechend bemessener Puls aus einer Laserquelle 72, 82, 92 auf die Kreuzungsstelle gelenkt und die galvanische Verbindung durch Schweissen verstärkt. Wahlweise hat man dann die Möglichkeit, einen Lichtleiter einzusetzen oder ohne einen solchen zu arbeiten.

Dir hier lediglich exemplarisch dargestellte Vorrichtung 71-74, 81-83, 91-94 kann Teil aus einem Multikontaktierkopf sein. Hier wird man dann neben einem simultanen mechanischen Kontaktiervorgang noch einen seriellen nachträglichen Schweissvorgang, da man nicht beliebig viele Laserquellen auf einem kleinen Raum anordnen kann. Somit werden die Kreuzungspunkte nachträglich mit dem Laser abgefahren und verschweisst, die man verschweisst haben möchte. Das müssen nicht alle Kontaktpunkte sein. Dabei kann eine gewisse Parallelisierung des Vorganges erreicht werden, durch eine Vervielfachung von Schweiss-Stellen über Lichtleiter, wobei mehr als eine Laserquelle eingesetzt werden kann. Das Prinzip eines Multi-Mikrokontaktierkopfes ist im Zusammenhang mit den Figuren 4 und 5 schon diskutiert worden. Ebenfalls die Beabstandung der Kontaktierstellen zueinander und die Art und Weise, wie ein Substrat zum Kontaktieren am Kopf entlang bewegt wird. Dies kann über Kopf oder unter Kopf bzw. in jeder gewünschten Position geschehen.

## Ansprüche

1. Verfahren zum Herstellen von elektrischen Verbindungen und/oder zum Trennen von Leiterbahnen auf einem Substrat mit einem Universalmuster von Leiterbahnen und Verbindungsstellen, dadurch gekennzeichnet, dass aus der Menge von allen Verbindungsmöglichkeiten des Substrats eine für die Verdrahtung eines vorgegebenen elektrischen Schaltbildes nötige Untermenge errechnet wird, dass aus den Daten dieser Untermenge Steuerdaten zur Führung mindestens eines Kontaktiermittels hergestellt werden, dass aufgrund dieser Daten ein Kontaktier- und oder Trennvorgang an den Leiterbahnen und Kontaktstellen des Substrates durchgeführt wird, dass die durchgeführte Verdrahtung geprüft wird und die Prüfdaten zur Ermittlung der Menge von zusätzlichen, das vorgegebene elektrische Schaltbild verdrahtenden Verdrahtungsmöglichkeiten verwendet werden, welche für eine eventuelle Nacharbeitung des Substrates zur Verfügung gestellt werden.

2. Verfahren nach Anspruch 1, dadurch gekennzeichnet, dass das verdrahtete Universalsubstrat zu einer weiteren Verdrahtung, welche die zusätzlichen Verdrahtungsmöglichkeiten benützt, zurückgeführt wird.

3. Verfahren nach Anspruch 2, dadurch gekennzeichnet, dass nach einer Rückführung die durchgeführte Verdrahtung geprüft wird und die Prüfdaten zur Ermittlung der Menge von zusätzlichen, das vorgegebene elektrische Schaltbild verdrahtenden Verdrahtungsmöglichkeiten werwendet werden, welche für eine weitere Nacharbeitung des Substrates zur Verfügung gestellt werden.

4. Verfahren nach einem der Ansprüche 2 oder 3, dadurch gekennzeichnet, dass die Rückführung und Ermittlung von zusätzlichen Verdrahtungsmöglichkeiten und Nachbearbeitung rekursiv geschieht.

5. Verfahren nach einem der Ansprüche 1 bis 4, dadurch gekennzeichnet, dass mit den Steuerdaten eine Multi-Mikrokontaktiervorrichtung gesteuert wird.

6. Verfahren nach Anspruch 5, dadurch gekennzeichnet, dass die Kontaktiervorrichtung so gesteuert wird, dass schrittweise ein modularer Abstand versetzt wird, wobei die Kontaktierstellen ein Mehrfaches des modularen Abstandes voneinander beabstandet sind.

7. Verfahren nach einem der Ansprüche 1 bis 4, dadurch gekennzeichnet, dass ein Operator (O*), der für die Neuoptimierung einer Verdrahtung des schon bearbeiteten Universalsubstrates definiert wird, im Bearbeitungs-Prozess derart wirkt, dass beim einmaligen Durchlauf eines Substrats eine virtuelle Nachoptimierung geschieht, also das Korrekturpotential nicht verwendet wird, bzw. beim Mehrmalsdurchlauf eine reelle Nachoptimierung geschieht und damit das Korrekturpotential verwendet wird.

8. Verfahren nach Anspruch 7, dadurch gekennzeichnet, dass die Daten 67 des anwendungsspezifischen Substratplans einerseits einem Berechnungsvorgang 74 zur Ermittlung des optimalen Kontaktiervorgangs zugeführt werden, welcher dafür auch die Kenndaten 64 der Kontaktiervorrichtung (Pt. 4) benötigt, dass sie andererseits einem weiteren Berechnungsvorgang 75 zum Festlegen des Prüfungsvorganges zugeführt werden, welcher auch die Kenndaten 65 der Prüfvorrichtung (Pt. 5) benötigt und dass aus den beiden Berechnungsvorgängen die Steuerdaten 61 für die Kontaktiervorrichtung (Pt. 1) und die Steuerdaten 62 für die Prüfvorrichtung (Pt. 2) gebildet werden.

9. Verfahren nach Anspruch 8, dadurch gekennzeichnet, dass anschliessend an die Kontaktierung 71 des Substrates in der Kontaktiervorrichtung die Prüfung 72 des verdrahteten Substrates in der Prüfvorrichtung durchgeführt wird und in der Prüfvorrichtung das Substrat ausgemessen und auf die Vorgaben, das ist der Verdrahtungsplan oder die Verdrahtung des elektrischen Schaltplans, aus dem Rechner geprüft (80) wird.

10. Verfahren nach Anspruch 9, dadurch gekennzeichnet, dass, wenn die Vorgaben erfüllt (81) werden, das Substrat als brauchbar weitergegeben (83), und wenn die Vorgaben nicht erfüllt (82) werden und keine Rückführung geplant ist, das Substrat in den Ausschuss (84) geführt wird.

11. Verfahren nach Anspruch 7, dadurch gekennzeichnet, dass für den Fall, wo eine Rückführung bei nicht erfüllten Vorgaben erfolgen muss, nach einer identischen Initialisierung 89 und Kontaktierung 71, bei der Prüfung 72 eine Auswertung 76 der bestehenden Verbindungen erfolgt.

12. Verfahren nach Anspruch 7 oder 11, dadurch gekennzeichnet, dass die Ermittlung der zusätzlichen Verdrahtungsmöglichkeit in zwei Stufen erfolgt, wobei zunächst mit einfacheren Verfahren 78 festgestellt wird, ob überhaupt eine korrigierende Verbindungsauslegung möglich ist (85) und, falls das der Fall ist (86), die aufwendigere Optimierung 70' unter Einbezug aller Kriterien durchgeführt wird.

13. Verfahren nach Anspruch 12, dadurch gekennzeichnet, dass aus der Optimierung 70' die Daten 67' des korrigierten Substratplanes bzw. der durchzuführenden Korrekturkontaktierungen entnommen werden und daraus einerseits, zusammen mit den Kenndaten 64 der Kontaktiervorrichtung (Pt. 4) der optimale (Korrektur-)Kontaktiervorgang 74' und andererseits zusammen mit den Kenndaten 65 der Prüfvorrichtung (Pt. 5) der Prüfungsvorgang 75' berechnet werden und mit den entsprechenden Daten 61', 62' eine neuerliche Kontaktierung und Prüfung durchgeführt wird.

14. Verfahren nach Anspruch 7, dadurch gekennzeichnet, dass an Stelle der Daten 63 des gewünschten elektrischen Schaltplans die Verbindungen des idealen Substrates als Daten 63″ des elektrischen Schaltplans vorgegeben werden, wobei in einem ersten Durchgang der Kontaktier- und oder Trennvorgang entfällt und somit die bezüglichen Steuerdaten 61″ ohne Berechnungsvorgang bestimmt sind und direkt dem Kontaktiervorgang 71 (Pt. 1) zur Verfügung gestellt werden.

15. Verfahren nach Anspruch 14, dadurch gekennzeichnet, dass in einer zusätzlichen Verzweigung 77 geprüft wird, ob es sich um den ersten Durchlauf handelt und falls dem so ist (78), gemäss den Ansprüchen 11 bis 13 verfahren wird.

16. Vorrichtung zum Herstellen von elektrischen Verbindungen und/oder zum Trennen von Leiterbahnen auf einem Substrat mit einem Universalmuster von Leiterbahnen und Verbindungsstellen, gekennzeichnet durch eine Mikrokontaktiereinheit (2, 4) und durch eine Mikromesseinheit (3, 5), einen Rechner (1) zur Berechnung der Steuerdaten für die Mikrokontaktier- (2, 4) und Mikromesseinheit (3, 5), sowie eine Vorrichtung (6, 7, bzw. 6-11) zur Zuführung von Universalsubstraten zur Mikrokontaktiereinheit (2, 4) und von dieser zur Mikromesseinheit (3, 5) und von dieser wieder zur Mikrokontaktiereinheit (2, 5).

17. Vorrichtung nach Anspruch 16, dadurch gekennzeichnet, dass die Mikrokontaktiereinheit (2, 4) einen Steuerungsteil (2) und einen Multi-Mikrokontaktierteil (4) aufweist.

18. Vorrichtung nach Anspruch 16, gekennzeichnet durch eine Anordnung mit einem Rechner (1), der die Kenndaten für die Steuerungen und die Schaltplandaten erhält, die Verdrahtungsoptimierung des Universalsubstrates durchrechnet und sie in Steuerdaten für die Steuerung (2) des Mikrokontaktierers (4) und die Steuerung (3) für das Prüfgerät mit dem Mikromessfühler (5) umsetzt, mit welchen Daten diese beiden Geräte über dem Substrat positioniert werden, sowie zwei Transporteinrichtungen (6, 7), die durch die Steuerung (2) der Mikrokontaktiervorrichtung und die Steuerung (3) der Prüfvorrichtung gesteuert werden, wobei ein Antrieb (8) der Transportvorrichtung (6), welche die Rohlinge der Kontaktierung und die programmierten Substrate der Prüfvorrichtung zuführt, durch die Steuerung (2) der Mikrokontaktiervorrichtung gesteuert und ein Antrieb (9) der Transportvorrichtung (7), welche Ausschuss-Substrate zur Korrekturkontaktierung rückführt, durch die Steuerung (3) der Prüfvorrichtung gesteuert ist.

19. Vorrichtung nach Anspruch 17, gekennzeichnet durch einen Führungskörper (15), der eine matrixähnliche Anordnung von Durchstichen (16) aufweist, durch welche die Kontaktierelemente (17) geführt und axial bewegbar sind und von einem Antriebsmittel (18), gesteuert angetrieben werden.

20. Vorrichtung nach Anspruch 19, dadurch gekennzeichnet, dass die Durchstiche in einem Abstand (DN) angeordnet sind, der ein ganzzahliges Vielfaches des Kreuzungs- oder Leiterabstandes (DK) des Substrates beträgt, wobei die Strecke (DK) des Kreuzungsabstandes die Einheit der Positionierschritte darstellt, in welchen der Kontaktierkopf über dem Substrat positioniert wird.

21. Vorrichtung nach Anspruch 16, dadurch gekennzeichnet, dass die Mikrometereinheit (2, 4) mindestens eine Kontaktierelement (17) in Form einer Hohlführungen (71, 81, 91) enthält, bei welcher durch die innere Oeffnung Energie zur wahlweisen nachträglichen Verschweissung nach mechanischer Verformung der Leiterbahnen einbringbar ist.

22. Vorrichtung nach Anspruch 21, dadurch gekennzeichnet, dass sie für die mechanische Kontaktierung der Leiterbahnen (L1, L2) einen aus der Hohlführung verschiebbaren, druckausübungsfähigen Lichtleiter (83) aufweist.

23. Vorrichtung nach Anspruche 21, dadurch gekennzeichnet, dass für die mechanische Kontaktierung eine Hohlführung einen Kontaktierring (74, 94) aufweist, der auf die mechanische Belastung ausgelegt ist.

24. Vorrichtung nach einem der Ansprüche 21 bis 23, dadurch gekennzeichnet, dass eine Laserquelle (72, 82, 92) vorgesehen ist, mit der Laserenergie entweder direkt durch den Hohlraum oder über einen Lichtleiter (83, 93) auf die zuvor mechanisch kontaktierten Leiter ($L_1$ und $L_2$) gebracht werden kann.

25. Vorrichtung nach einem der Ansprüche 21 bis 24, dadurch gekennzeichnet, dass Hohlführungen, Lichtleiter und Laserquelle (71-74, 81-83, 91-94) Teil aus einem Multikontaktierkopf der Multikontaktiereinheit (5) sind.

26. Universalsubstrat, kontaktiert gemäss dem Verfahren nach Anspruch 1, dadurch gekennzeichnet, dass es zur der Substratunterlage freie, mechanisch verformte, auf eine kreuzende Leiterbahn gepresste und/oder mit der kreuzenden Leiterbahn verschweisste Leiterbahnbrücken und/oder aufgetrennte Leiterbahnen aufweist.

EP 0 430 864 A2

GP

AP1

AP3

AP13

AP2

VP

FIG. 1A

GP

AP

FVP

KP    R

FIG. 1B

18

17

15

16

DN

DK

FIG. 5

FIG. 2

SPE

OPTIMIER-GERÄT — RECHENTEIL

O*

SPS

PRÜF-MASCHINE — RECHENTEIL / STEUERTEIL / MESSTEIL

KONTAKTIER-MASCHINE — RECHENTEIL / STEUERTEIL / ELEKTRODENTEIL

ROHLING

WERKSTÜCK

PRÜFLING

PRODUKT

AUSSCHUSS

14

FIG. 3A

FIG. 3B

63" □ □ 60

Pt.3 ○ ○

70

67" □ □ 65

Pt.5

75

61" □ □ 62

Pt.1 ○ Pt.2 ○

71
72
76

80
81
82

77 78

63 □

Pt.3 ○

66

89

87"

88"

B B

FIG. 3C

FIG.4

KENNDATEN → RECHNER ← SCHALTPLANDATEN

1

STEUERDATEN          STEUERDATEN

2          3

STEUERUNG ←→ O* ←→ STEUERUNG

4          5

MIKROKONTAKTIERER          MIKROMESSFÜHLER

11          6          10

8          7          9

EP 0 430 864 A2

FIG. 6

A        B        C

FIG. 7

A        B        C

FIG. 8

A        B        C

FIG. 9

FIG . 10

21